# EUROPÄISCHE PATENTSCHRIFT

(11) **EP 0 662 709 B1**
(45) Veröffentlichungstag und Bekanntmachung des Hinweises auf die Patenterteilung: **25.03.1998**
(21) Anmeldenummer: 95100010.8
(22) Anmeldetag: 02.01.1995
(51) Int. Cl.: H01L 21/66

(54) **Testverfahren für Halbleiterschaltungsebenen**
Method of testing semiconductor circuit layers
Méthode de test de couches de circuit semi-conducteur

(30) Priorität: 11.01.1994 DE 4400552
(43) Veröffentlichungstag der Anmeldung: 12.07.1995
(73) Patentinhaber: SIEMENS AKTIENGESELLSCHAFT, 80333 München (DE)
(72) Erfinder: Weber, Werner, Dr., D-80637 München (DE); Klose, Helmut Dr., D-81929 München (DE); Hübner, Holger Dr., D-85598 Baldham (DE); Köppe, Siegmar, Dipl.-Ing., D-30880 Laatzen (DE)

(56) Entgegenhaltungen:
- WO-A-88/02549
- WO-A-90/09093
- US-A- 5 222 014
- US-A- 5 315 239

## Beschreibung

Die vorliegende Erfindung betrifft ein Verfahren zur Durchführung von Funktionstests an einzelnen Halbleiterschaltungsebenen, die für vertikale Integration vorgesehen sind.

Halbleiterschaltungen werden heute in Planartechnik hergestellt. Die erreichbare Komplexität auf einem Chip ist begrenzt durch dessen Größe und die erreichbare Strukturfeinheit. Die Leistungsfähigkeit eines Systems bestehend aus mehreren miteinander verbundenen Halbleiterchips ist bei konventioneller Technik wesentlich begrenzt durch die begrenzte Zahl der möglichen Verbindungen zwischen einzelnen Chips über Anschlußkontakte (Pads), die geringe Geschwindigkeit der Signalübermittlung über solche Verbindungen zwischen verschiedenen Chips (Interface-Schaltungen Pad/Leiterplatte), die bei komplexen Chips begrenzte Geschwindigkeit durch weit verzweigte Leiterbahnen und den hohen Leistungsverbrauch der Interface-Schaltungen.

Diese aufgezeigten Beschränkungen bei der Verwendung der Planartechnik lassen sich mit dreidimensionalen Techniken der Verschaltung überwinden. Die Anordnung der Funktionsebenen übereinander erlaubt eine parallele Kommunikation dieser Komponenten mit geringem Aufwand elektrisch leitender Verbindungen in einer Ebene, und außerdem werden geschwindigkeitsbegrenzende Interchip-Verbindungen vermieden. Außerdem kann ein solcher vertikal integrierter Chip trotz gesteigerter Funktionalität im gleichen Gehäuse untergebracht werden.

Um keinen vermeidbaren Verlust bei der Ausbeute funktionsfähiger Chips zu erleiden, ist es erforderlich, daß nur getestete und für voll funktionstüchtig befundene Schaltungsebenen miteinander verbunden werden. Das ist solange unproblematisch, wie es sich bei den Schaltungsebenen um autarke, d. h. selbständig funktionierende Schaltungen handelt. Bei solchen autarken Schaltungen ist es möglich, sie schon auf dem Wafer, auf dem sie hergestellt werden, zu testen, bevor man sie vereinzelt und in Gehäusen montiert. Wenn die einzelne Schaltungsebene allerdings erst im Zusammenspiel mit den vertikal anzuordnenden Nachbarebenen funktioniert bzw. wegen fehlender Kontakt flecken eine Spitzenkontaktierung auf dem Wafer nicht möglich ist, dann ist das Testen ohne weitere Maßnahmen erst nach einem Zusammenbau der Schaltungsebenen, der allerdings irreversibel ist, möglich. Die Ausbeute ist dann allerdings drastisch reduziert.

Üblicherweise werden die Schaltungen zum Testen durch Aufsetzen feiner Prüfspitzen auf die Bondpads kontaktiert. Die Pads haben aber wesentlich größere Abmessungen als die Verbindungskontakte der für vertikale Integration vorgesehenen Schaltungsebenen. Außerdem ist die Zahl der Kontakte dabei wesentlich größer (etwa 10.000 bis 100.000). Die feinen Abmessungen und die hohe Anzahl der Kontaktstellen schließen die Verwendung der üblichen Testspitzen aus. Ein anderes Testverfahren verwendet elektronenoptische Methoden. Das erfordert aber autarke Schaltungsebenen, eine Voraussetzung die hier nicht erfüllt ist. Insbesondere ist bei isolierten Schaltungsebenen die Spannungsversorgung noch nicht gewährleistet.

Aufgabe der vorliegenden Erfindung ist es, ein Verfahren zum Durchführen von Funktionstests für vertikal integrierte Halbleiterbauelemente anzugeben, das gegenüber herkömmlichen Verfahren eine erhöhte Ausbeute funktionsfähiger Chips ermöglicht.

Diese Aufgabe wird mit dem Verfahren mit den Merkmalen des Anspruches 1 gelöst. Weitere Ausgestaltungen ergeben sich aus den abhängigen Ansprüchen.

Bei dem erfindungsgemäßen Verfahren werden die einzelnen Halbleiterschaltungsebenen vor dem Zusammenbau auf ihre Funktion getestet. Die Grundidee der vorliegenden Erfindung ist dabei, die im fertigen Bauelement ober- bzw. unterhalb der zu testenden Schaltungsebene anzuordnenden weiteren Schaltungsebenen für diesen Test nachzubilden. Wenn das fertige Bauelement z. B. n vertikal miteinander verbundene Schaltungsebenen aufweist und daraus die i-te Schaltungsebene getestet werden soll, werden jeweils der Stapel der ersten i-1 Schaltungsebenen und der Stapel der letzten n-i Schaltungsebenen in Form von Testköpfen nachgebildet. Beim Funktionstest wird die i-te Schaltungsebene beidseitig mit den entsprechenden Testköpfen reversibel verbunden, wobei die Anschlußkontakte dieser Schaltungsebene mit an den Testköpfen jeweils gegenüberliegend angeordneten Kontakten verbunden werden. Die Kontakte an den Testköpfen werden jeweils so ausgestaltet, daß die Testköpfe nach dem Funktionstest von der getesteten Schaltungsebene leicht entfernt werden können. Diejenigen getesteten Schaltungsebenen, die funktionstüchtig sind, können dann für den Zusammenbau der Bauelemente eingesetzt werden.

Eine einfache Realisation der Testköpfe ist z. B. dadurch gegeben, daß die ersten i-1 Schaltungsebenen des betreffenden Bauelementes zusammengebaut werden, und ggf. aus einer Vielzahl solcher Stapel aus i-1 Schaltungsebenen ein vollständig funktionsfähiger Stapel selektiert wird. Entsprechend werden Stapel, die aus den letzten n-i Schaltungsebenen bestehen, zusammengebaut und daraus ein voll funktionstüchtiger Stapel ausgewählt. Wenn die jeweils der zu testenden Schaltungsebene zugewandten Anschlußkontakte dieser als Testköpfe vorgesehenen Stapel so ausgebildet sind, daß eine reversible Kontaktierung mit der zu testenden Schaltungsebene möglich ist, können diese Stapel direkt als Testköpfe in dem erfindungsgemäßen Verfahren eingesetzt werden.

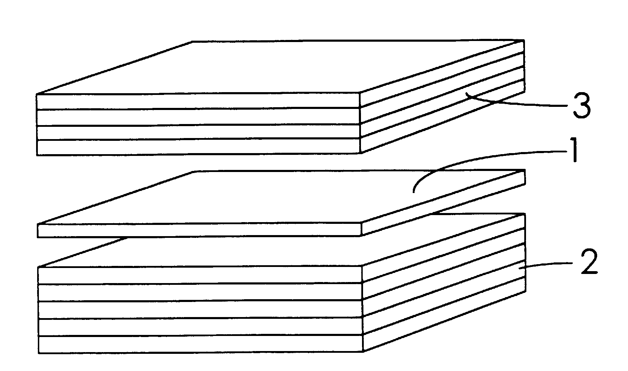

Alternativ ist es auch möglich, zusätzliche Schaltungen in die Testköpfe zu integrieren. Diese Schaltungen können z. B. für bestimmte Testzwecke, z. B. das Generieren von Testsignalen, vorgesehen sein. Die Verwendung von Testköpfen, die aus Stapeln von für das Bauelement vorgesehenen Schaltungsebenen gebildet sind, wird in der Figur im Schema dargestellt. Die zu testende Schaltungsebene 1 wird auf beiden Seiten mit je einem Testkopf 2, 3 kontaktiert, der die jeweils auf dieser Seite im fertigen Bauelement angeordneten Schaltungsebenen enthält.

Die Komplexität vertikal integrierter Schaltungen hat zur Folge, daß der Funktionstest auch einer Einzelebene gegenüber üblichen zweidimensionalen Schaltungen wesentlich komplizierter ist. Um einen Test der gesamten Schaltung bei dem Test einer Einzelebene zu vermeiden, kann eine geeignete Aufteilung der Schaltung vorgenommen werden. In der für das erfindungsgemäße Verfahren eingesetzten Anordnung muß diese Aufteilung allerdings nicht notwendigerweise auf eine bestimmte Schaltungsebene beschränkt sein, wie dies bei herkömmlichen Testanordnungen nötig ist. Es kann daher genügen, wenn die Testköpfe jeweils nur Teilfunktionen der auf der betreffenden Seite der zu testenden Schaltungsebene in dem fertigen Bauelement angeordneten Schaltung enthalten. Speziell kann ein solcher Testkopf z. B. nur aus einer bestimmten Anzahl von der zu testenden Schaltungsebene im fertigen Bauelement benachbart angeordneten Schaltungsebenen zusammengesetzt sein. Beim Test der i-ten Schaltungsebene 1 würde der untere Testkopf 2 z. B. die Schaltungsebenen i-10 bis i-1 umfassen und der obere Testkopf 3 die Schaltungsebenen i+1 bis i+8. Zum Testen derart gestalteter Teilstapel sind allerdings Mittel vorzusehen, die eine Kontaktierung für elektrischen Anschluß nach außen ermöglichen (z. B. Kontaktflecken auf den äußersten Schaltungsebenen, die mit Spitzen oder Bonddrähten kontaktiert werden können). Diese Vorgehensweise kann ein wesentlicher Vorteil sein, wenn Funktionstests an Einzelebenen von Bauelementen durchgeführt werden müssen, in denen Funktionsblöcke vertikal angeordnet sind (z. B. Sensorschicht mit darunterliegender elektronischer Datenverarbeitung). Das erfindungsgemaße Verfahren bietet allgemein Vorteile, wenn ein funktioneller Test vorteilhaft ist und ein sogenannter struktureller Test (mit geeigneter Aufteilung der Gesamtfunktion in Teilfunktionen) nicht sinnvoll ist. In der Bildverarbeitung kann dies beispielsweise der Fall sein, wenn ein Test durch Vergleich von Soll- und Ist-Muster schnell und mit geringem Aufwand durchgeführt werden kann.

Das erfindungsgemaße Verfahren vermeidet den zusätzlichen Aufwand einer eigenen Hardware-Entwicklung zum Testen einer bestimmten vertikalen Schaltung, da ja immer der gesamte vertikale Chip getestet wird, wenn die zu testende Schaltungsebene während des Funktionstests durch die Testköpfe zu einer Gesamtschaltung ergänzt ist. Aus demselben Grund ist die Schnittstelle zum eigentlichen Test-Equipment für den Test jeder Schaltungsebene eines vertikalen Chips gleich, was ebenfalls zur Verringerung des Testaufwandes führt.

Die Testköpfe können statt aus einem Zusammenbau von für das Bauelement vorgesehenen Schaltungsebenen auch in anderer Form realisiert sein, z. B. als zweidimensionale Schaltung, die in einem der Abmessung der zu testenden Schaltungsebene entsprechenden Bereich mit den erforderlichen Anschlußkontakten versehen ist. Die für die reversible Kontaktierung erforderlichen speziellen Anschlußkontakte lassen sich z. B. als Flüssigkontakte realisieren. Bei derartigen Flüssigkontakten ist z. B. ein flüssiges Metall wie Gallium in eine Aussparung, deren Wände mit einer Metallisierung versehen sind, eingebracht. Das flüssige Metall benetzt die Metallisierungen, um gute elektrische Leitung zu gewährleisten. Die Metallisierungen sind mit elektrisch leitenden Verbindungen versehen, die dem elektrischen Anschluß dienen. Die Flüssigkontakte bilden jeweils über die Oberfläche hinausragende Menisken, so daß beim Aufpressen auf die anzuschließende Oberfläche der zu testenden Schaltungsebene ein Kontakt zwischen den Anschlußflächen dieser Schaltungsebene und den Flüssigkontakten hergestellt wird. Die mit Flüssigkontakten versehenen Testköpfe lassen sich einfach von der zu testenden Schaltungsebene entfernen, insbesondere wenn die Adhäsionskräfte durch Aufrauhen oder Beschichten der Oberflache der Testköpfe vermindert sind.

Beim Testen der untersten bzw. obersten Schaltungsebene des Bauelementes wird jeweils nur ein Testkopf eingesetzt. Ggf. ist auch das Design der Schaltungsebenen an dieses erfindungsgemäße Verfahren anzupassen, z. B. was die Ausgestaltung der Anschlußkontakte und die für eine ausreichende Stabilität erforderliche Mindestdicke betrifft.

## Patentansprüche

1. Verfahren zum Durchführen von Funktionstests an Halbleiterschaltungsebenen (1) für vertikal integrierte Halbleiterbauelemente,
bei dem Testkopfe (2, 3) verwendet werden,
die jeweils zumindest einen Teil der Funktionen eines über oder unter der zu testenden Schaltungsebene (1) im fertiggestellten Halbleiterbauelement vorgesehenen Stapels von Schaltungsebenen (1) nachbilden und
die an den Stellen an der Oberfläche der zu testenden Schaltungsebene (1), die beim Funktionstest elektrisch anzuschließen sind, mit Vorrichtungen für reversible Kontaktierung versehen sind, und
bei dem die zu testende Schaltungsebene (1) nur während des Funktionstests ein- oder beidseitig mit einem derartigen Testkopf (2, 3) verbunden wird.

2. Verfahren nach Anspruch 1,
bei dem Testkopfe (2, 3) verwendet werden, die aus je einem Stapel von solchen Schaltungsebenen zusammengesetzt sind, wie sie auch für das fertiggestellte Bauelement oberhalb oder unterhalb der zu testenden Schaltungsebene vorgesehen sind.

3. Verfahren nach Anspruch 2,
bei dem die Testköpfe jeweils alle für das fertiggestellte Bauelement oberhalb oder unterhalb der zu testenden Schaltungsebene vorgesehenen Schaltungsebenen enthalten.

4. Verfahren nach einem der Ansprüche 1 bis 3,
bei dem die in den Testköpfen (2, 3) realisierten Schaltungen zusätzlich zur Nachbildung von durch Stapel von Schaltungsebenen im fertigen Bauelement gegebenen Funktionen auch Funktionen besitzen, die speziell für den Funktionstest der zu testenden Schaltungsebene vorgesehen sind.

## Claims

1. Method for carrying out function tests on semiconductor circuit planes (1) for vertically integrated semiconductor components,
in which test heads (2, 3) are used,
which in each case simulate at least some of the functions of a stack of circuit planes (1) that is provided above or below the circuit plane (1) to be tested in the completed semiconductor component, and
which are provided with apparatuses for reversible contact-making at the locations on the surface of the circuit plane (1) to be tested which are to be electrically connected during the function test, and
in which the circuit plane (1) to be tested is connected to such a test head (2, 3) on one or both sides only during the function test.

2. Method according to Claim 1,
in which test heads (2, 3) are used which are each composed of a stack of circuit planes such as are also provided for the completed component above or below the circuit plane to be tested.

3. Method according to Claim 2,
in which the test heads in each case contain all of the circuit planes provided for the completed component above or below the circuit plane to be tested.

4. Method according to one of Claims 1 to 3,
in which the circuits realized in the test heads (2, 3), in addition to simulating functions provided by stacks of circuit planes in the finished component, also have functions intended specifically for the function test of the circuit plane to be tested.

## Revendications

1. Procédé pour l'exécution de tests fonctionnels sur des plans de circuits à semi-conducteurs (1) pour composants à semi-conducteurs à intégration verticale,
dans lequel on utilise des têtes de test (2, 3)
qui reproduisent chacune au moins une partie des fonctions d'une pile de plans de circuits (1) qui est prévue au-dessus ou au-dessous du plan de circuit (1) à tester dans le composant à semi-conducteurs fini et
qui sont munis de dispositifs pour l'établissement réversible d'un contact aux endroits de la surface du plan de circuit (1) à tester qui doivent être connectés électriquement au cours du test fonctionnel, et
dans lequel le plan de circuit (1) à tester n'est connecté à une tête de test (2, 3) de ce type, sur une face ou sur les deux faces, que pendant le test fonctionnel.

2. Procédé selon la revendication 1,
dans lequel on utilise des têtes de test (2, 3) qui sont composées chacune d'une pile de plans de circuits tels que ceux prévus aussi pour le composant fini au-dessus et au-dessous du plan de circuit à tester.

3. Procédé selon la revendication 2,
dans lequel les têtes de test contiennent respectivement tous les plans de circuits prévus pour le composant fini au-dessus et au-dessous du plan de circuit à tester.

4. Procédé selon une des revendications 1 à 3,
dans lequel les circuits réalisés dans les têtes de test (2, 3) possèdent, en supplément de celles prévues pour la reproduction de fonctions assurées dans le composant fini par une pile de plans de circuits, également des fonctions qui sont prévues spécialement pour le test fonctionnel du plan de circuit à tester.
